# EUROPEAN PATENT APPLICATION

(11) **EP 1 758 242 A1**
(43) Date of publication of application: **28.02.2007**
(21) Application number: 04746117.3
(22) Date of filing: 18.06.2004
(51) Int. Cl.: H03F 1/07, H03F 1/32, H03F 3/19

(54) **HIGH-EFFICIENCY AMPLIFIER**

(71) Applicant: MITSUBISHI ELECTRIC CORPORATION, Chiyoda-ku Tokyo 100-8310 (JP)
(72) Inventor: HORIGUCHI, Kenichi, MITSUBISHI DENKI K.K., Tokyo, 1008310 (JP); NAKAYAMA, Masatoshi, MITSUBISHI DENKI K.K., Tokyo, 1008310 (JP); TAKAGI, Tadashi, MITSUBISHI DENKI KABUSHIKI KAISHA, Tokyo, 1008310 (JP)
(74) Representative: Pfenning, Meinig & Partner GbR
(86) International application number: PCT/JP2004/008615
(87) International publication number: WO 2005/124994

(57) **Abstract**

A high efficiency amplifier has an analog predistortion circuit (5) connected between an input side dividing circuit (2) and a quarter-wave line (6). This offers an advantage of being able to improve the linearity of the entire amplifier because the nonlinear distortion of a peak amplifier (7) is compensated.

## Description

### TECHNICAL FIELD

The present invention relates to a high efficiency amplifier for linearly amplifying an RF (Radio Frequency) signal, for example, at high efficiency.

### BACKGROUND ART '

It is desired that RF amplifiers used for broadcasting and communication amplify an input signal, an RF signal, linearly at high efficiency.
However, as for amplifiers in general, increasing the efficiency is incompatible with increasing the linearity.
The efficiency of the amplifier increases with the power level of the input signal, and achieves the maximum efficiency near the saturation point of the amplifier. When the power of the input signal increases to a complete saturation area, the efficiency reduces conversely.

As for modulating waves with a large PAPR (Peak to Average Power Ratio) which have been used recently in broadcasting and mobile communications, when they are input to an amplifier, their linearity is deteriorated greatly because of the input signal waveform clipping caused by the saturation of the amplifier at the operating point near the saturation point.
Thus, the broadcasting and communication RF amplifiers are usually used at an operation level with a large backoff from the saturation. Accordingly, it is important for the amplifiers to have high efficiency at the operation level with a large backoff from the saturation.
A Doherty amplifier (high efficiency amplifier) that increases its efficiency at the operation level with a large backoff from the saturation is disclosed in the following Relevant Reference 1.

In the conventional Doherty amplifier, an RF signal input via an input terminal is split by an input side dividing circuit, and is fed to two paths.
In the first path, a carrier amplifier amplifies the first RF signal fed from the input side dividing circuit, and supplies its output signal to an output side combining circuit via a quarter-wave line.
In the second path, the second RF signal fed from the input side dividing circuit passes through a quarter-wave line, and is amplified by a peak amplifier so that the output signal of the peak amplifier is supplied to the output side combining circuit.

However, when the instantaneous signal level of the RF signal is less than a specified level, the peak amplifier which is class B or class C biased is placed in an off state (in which the RF signal is not amplified) so that only the output signal of the carrier amplifier is supplied to the output side combining circuit.

In this case, when the load impedance seen by looking into the output terminal from the output side combining circuit is R/2, the output impedance of the peak amplifier becomes infinity (open) ideally. Accordingly, the load impedance seen by looking into the output side combining circuit from the post-stage quarter-wave line of the carrier amplifier becomes R/2, and the load impedance seen by looking into the post-stage quarter-wave line from the carrier amplifier becomes 2R.

In contrast, when the instantaneous signal level of the RF signal is greater than the specified level, the peak amplifier which is class B or class C biased is placed in an on state (in which the signal is amplified). Accordingly, the output side combining circuit combines the output signal of the carrier amplifier with the output signal of the peak amplifier to be output.
In this case, the load impedances seen by looking into the output side from the carrier amplifier and peak amplifier are both R.

Consider the case where the designed is made such that when the load impedance is 2R, the carrier amplifier has high efficiency even if its saturation power is small, and that when the load impedance is R, both the carrier amplifier and peak amplifier have large saturation power. In this case, it is possible for the carrier amplifier to operate at high efficiency when the instantaneous signal level of the RF signal is small, and for the carrier amplifier and peak amplifier to operate in such a manner as to increase the saturation power when the instantaneous signal level of the RF signal is large.

This offers an advantage of combining the output signal of the peak amplifier with the output signal of the carrier amplifier in response to the instantaneous signal level of the RF signal, and an advantage of varying the load impedance seen by looking into the output side from the carrier amplifier and peak amplifier in response to the instantaneous signal level of the RF signal. As a result, highly efficient operation can be implemented at the operation level with the large backoff from the saturation.

Relevant Reference 1: Japanese patent No. 2945833 (Paragraphs from [0018] to [0021], and FIG. 2)

With the foregoing configuration, the conventional high efficiency amplifier uses a class B or class C amplifier as the peak amplifier. Thus, it has a problem of deteriorating the linearity of the peak amplifier. In addition, since the carrier amplifier is designed to operate near the maximum efficiency point close to the saturation, it has a problem of degrading the linearity. Furthermore, when the instantaneous signal level of the RF signal is greater than the specified level, it has a problem of reducing the efficiency of the carrier amplifier beyond the maximum efficiency.

The present invention is implemented to solve the foregoing problems. Therefore it is an object of the present invention to provide a high efficiency amplifier capable of improving the linearity and efficiency at the operation level with the large backoff from the saturation.

### DISCLOSURE OF THE INVENTION

The high efficiency amplifier in accordance with the present invention is configured such that it has before a second amplifier a distortion compensation circuit for compensating for the nonlinear distortion of the second amplifier.

This offers an advantage of being able to improve the linearity and efficiency at the operation level with the large backoff from the saturation.

### BRIEF DESCRIPTION OF THE DRAWINGS

FIG. 1 is a block diagram showing a configuration of a high efficiency amplifier of an embodiment 1 in accordance with the present invention;
FIG. 2 is a graph illustrating input-output characteristics of the amplifier;
FIG. 3 is a block diagram showing a configuration of a high efficiency amplifier of an embodiment 2 in accordance with the present invention;
FIG. 4 is a block diagram showing a configuration of a high efficiency amplifier of an embodiment 3 in accordance with the present invention;
FIG. 5 is a block diagram showing a configuration of a high efficiency amplifier of an embodiment 4 in accordance with the present invention;
FIG. 6 is a block diagram showing a configuration of a high efficiency amplifier of an embodiment 5 in accordance with the present invention;
FIG. 7 is a block diagram showing a configuration of a high efficiency amplifier of an embodiment 6 in accordance with the present invention;
FIG. 8 is a block diagram showing a configuration of a high efficiency amplifier of an embodiment 7 in accordance with the present invention; and
FIG. 9 is a block diagram showing a configuration of a high efficiency amplifier of an embodiment 8 in accordance with the present invention.

### BEST MODE FOR CARRYING OUT THE INVENTION

The best mode for carrying out the invention will now be described with reference to the accompanying drawings to explain the present invention in more detail.

### EMBODIMENT 1

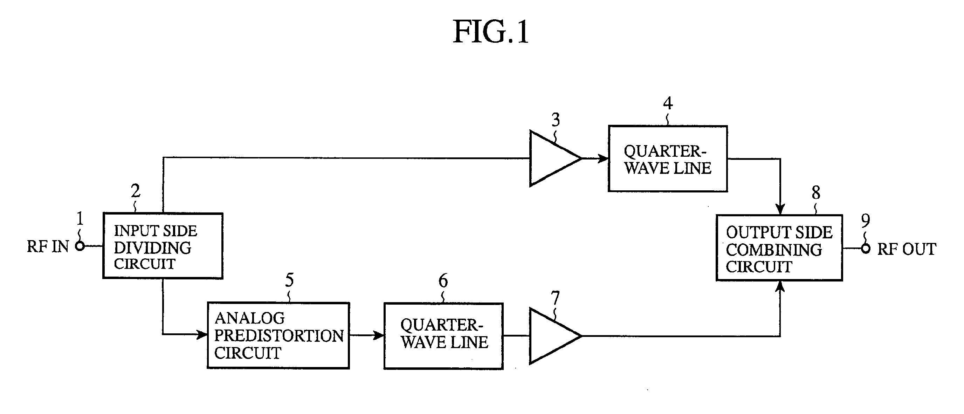

FIG. 1 is a block diagram showing a configuration of a high efficiency amplifier of an embodiment 1 in accordance with the present invention.

In FIG. 1, when an RF signal (input signal), for example, is input via an input terminal 1, an input side dividing circuit 2 splits the RF signal and supplies to two paths. The input side dividing circuit 2 constitutes an input signal dividing means.
A carrier amplifier 3, a first amplifier, amplifies the first RF signal fed from the input side dividing circuit 2, and supplies the amplified RF signal to a quarter-wave line 4.

An analog predistortion circuit 5, which is connected between the input side dividing circuit 2 and a quarter-wave line 6, is a distortion compensation circuit for compensating for the nonlinear distortion of a peak amplifier 7.
When the signal level (power) of the RF signal passing through the quarter-wave line 6 is greater than a specified signal level, the peak amplifier 7, a second amplifier, amplifies the RF signal.
An output side combining circuit 8 combines the RF signal passing through the quarter-wave line 4 with the RF signal output from the peak amplifier 7, and supplies the combined signal to an output terminal 9.

Next, the operation will be described.
When the RF signal is input via the input terminal 1, the input side dividing circuit 2 divides the RF signal, and supplies to the two paths.

In the first path, the carrier amplifier 3 amplifies the first RF signal fed from the input side dividing circuit 2.
The RF signal, which is the output signal of the carrier amplifier 3, passes through the quarter-wave line 4 to be supplied to the output side combining circuit 8.

In the second path, the second RF signal fed from the input side dividing circuit 2 passes through the quarter-wave line 6, and is amplified by the peak amplifier 7.
The RF signal, which is the output signal of the peak amplifier 7, is supplied to the output side combining circuit 8.
Since the analog predistortion circuit 5 is connected before the quarter-wave line 6 in the second path, the nonlinear distortion of the peak amplifier 7 has been compensated when the RF signal passing through the quarter-wave line 6 is input to the peak amplifier 7.

However, when the instantaneous signal level of the RF signal is smaller than the specified level, the class B or class C biased peak amplifier 7 becomes the off state (in which the RF signal is not amplified) so that the peak amplifier 7 does not supply the output signal to the output side combining circuit 8.
Thus, the output side combining circuit 8 supplies the RF signal output from the carrier amplifier 3 to the output terminal 9.

In this case, if the load impedance seen by looking into the output terminal 9 from the output side combining circuit 8 is R/2, the output impedance of the peak amplifier 7 becomes infinity (open) ideally. Accordingly, the load impedance seen by looking into the output side combining circuit 8 from the quarter-wave line 4 becomes R/2, and the load impedance seen by looking into the quarter-wave line 4 from the carrier amplifier 3 becomes 2R.

In contrast, when the instantaneous signal level of the RF signal is greater than the specified level, the class B or class C biased peak amplifier 7 is placed in an on state (in which the signal is amplified). Accordingly, the output side combining circuit 8 combines the output signal of the carrier amplifier 3 (the RF signal passing through the quarter-wave line 4) with the output signal of the peak amplifier 7 to be supplied to the output terminal 9.
In this case, the load impedances seen by looking into the output side from the carrier amplifier 3 and peak amplifier 7 are both R.

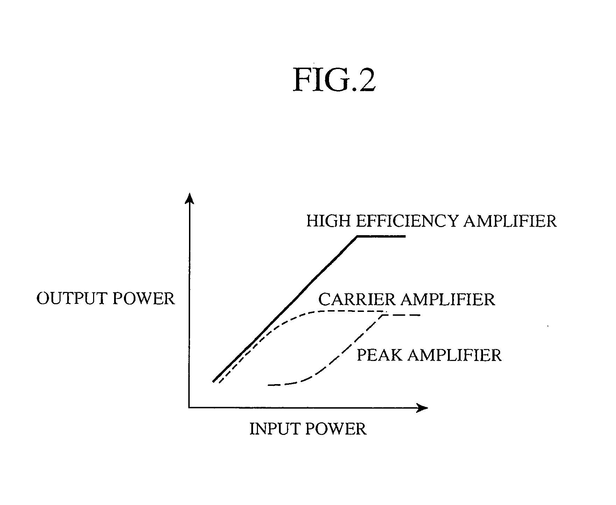

Consider the case where the designed is made such that when the load impedance is 2R, the carrier amplifier 3 has high efficiency even if its saturation power is small, and that when the load impedance is R, both the carrier amplifier 3 and peak amplifier 7 have large saturation power. In this case, it is possible for the carrier amplifier 3 to operate at high efficiency when the instantaneous signal level of the RF signal is small, and for the carrier amplifier 3 and peak amplifier 7 to operate in such a manner as to increase the saturation power when the instantaneous signal level of the RF signal is large (see, FIG. 2).

This offers an advantage of being able to combine the output signal of the peak amplifier 7 with the output signal of the carrier amplifier 3 in response to the instantaneous signal level of the RF signal, and an advantage of being able to vary the load impedance seen by looking into the output side from the carrier amplifier 3 and peak amplifier 7 in response to the instantaneous signal level of the RF signal. As a result, highly efficient operation can be implemented at the operation level with the large backoff from the saturation.

In addition, according to the present embodiment 1, since the analog predistortion circuit 5 is connected between the input side dividing circuit 2 and the quarter-wave line 6, the nonlinear distortion of the peak amplifier 7 is compensated, thereby offering an advantage of being able to improve the linearity of the entire amplifier.

### EMBODIMENT 2

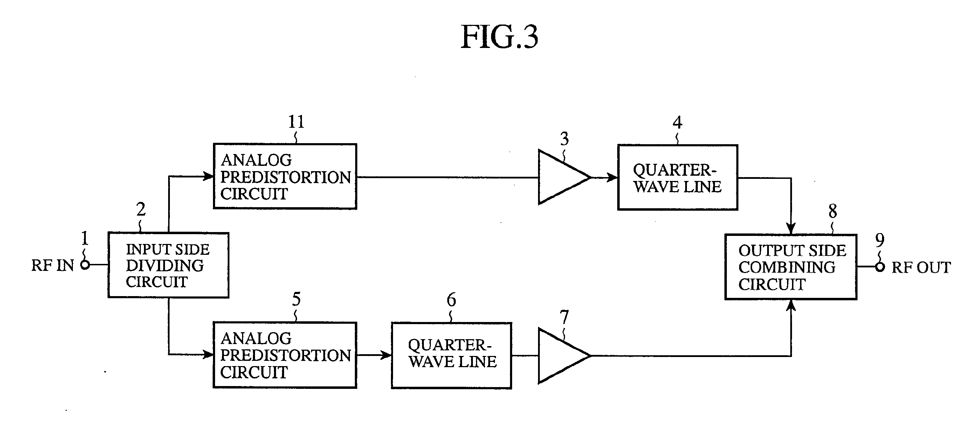

FIG. 3 is a block diagram showing a configuration of a high efficiency amplifier of an embodiment 2 in accordance with the present invention. In FIG. 2, since the same reference numerals designate the same or like portions to those of FIG. 1, their description is omitted here.
An analog predistortion circuit 11, which is connected between the input side dividing circuit 2 and the carrier amplifier 3, is a distortion compensation circuit for compensating for the nonlinear distortion of the carrier amplifier 3.

Although the foregoing embodiment 1 is described by way of example that connects the analog predistortion circuit 5 between the input side dividing circuit 2 and the quarter-wave line 6 to compensate for the nonlinear distortion of the peak amplifier 7, it is also possible to further connect the analog predistortion circuit 11 between the input side dividing circuit 2 and the carrier amplifier 3 to compensate for the nonlinear distortion of the carrier amplifier 3.
This offers an advantage of being able to further improve the linearity of the entire amplifier than the foregoing embodiment 1.

### EMBODIMENT 3

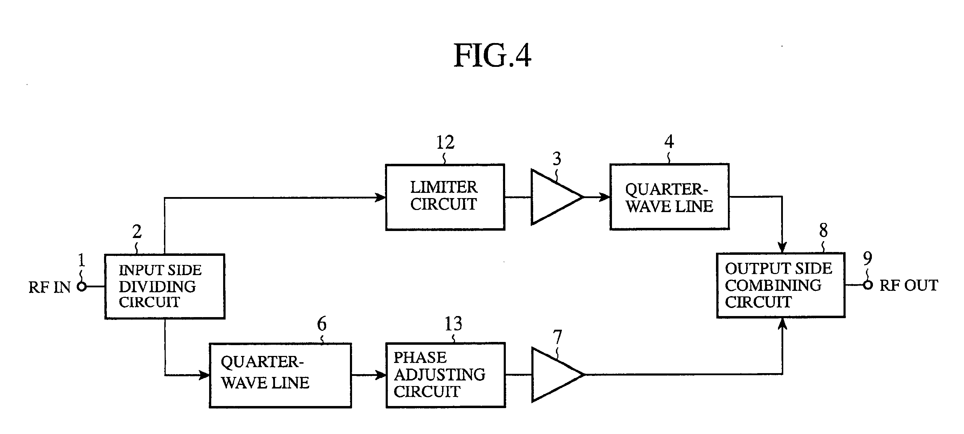

FIG. 4 is a block diagram showing a configuration of a high efficiency amplifier of an embodiment 3 in accordance with the present invention. In FIG. 4, since the same reference numerals designate the same or like portions to those of FIG. 1, their description is omitted here.
A limiter circuit 12 or a level limiting circuit limits, when the amplitude of the first RF signal fed from the input side dividing circuit 2 is greater than a specified level, the amplitude of the RF signal to below the specified level, and supplies it to the carrier amplifier 3.
A phase adjusting circuit 13 adjusts the RF signal so that the pass phase of the RF signal from passing through the carrier amplifier 3 to the output is matched to the pass phase of the RF signal from passing through the peak amplifier 7 to the output.

Next, the operation will be described.
The limiter circuit 12, the level limiting circuit, has a saturation characteristic that limits the amplitude of the RF signal level to a desired level.

More specifically, when the amplitude of the RF signal fed from the input side dividing circuit 2 is less than the specified level, the limiter circuit 12 supplies the RF signal to the carrier amplifier 3 without change. In contrast, when the amplitude of the RF signal is greater than the specified level, the limiter circuit 12 limits the amplitude of the RF signal to the specified level, and supplies it to the carrier amplifier 3.

Thus, it becomes possible to prevent the efficiency reduction in the area where the carrier amplifier 3 saturates completely by designing such that the upper limit of the amplitude of the RF signal limited by the limiter circuit 12 is placed near a region where the efficiency of the carrier amplifier 3 is maximum (the maximum efficiency is achieved near the saturation point of the carrier amplifier 3), which offers an advantage of being able to improve the efficiency and linearity of the entire amplifier.

### EMBODIMENT 4

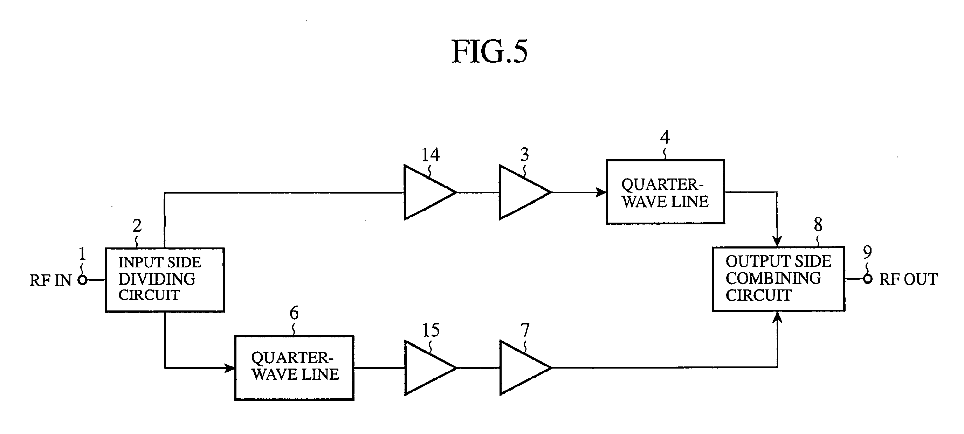

FIG. 5 is a block diagram showing a configuration of a high efficiency amplifier of an embodiment 4 in accordance with the present invention. In FIG. 5, since the same reference numerals designate the same or like portions to those of FIG. 1, their description is omitted here.
A driver amplifier 14 or a level limiting circuit is an amplifier for driving the carrier amplifier 3. The driver amplifier 14 limits, when the amplitude of the RF signal is greater than a specified level, the amplitude of the RF signal to below the specified level by its saturation characteristic, and supplies it to the carrier amplifier 3.
A driver amplifier 15 is an amplifier for driving the peak amplifier 7.

Next, the operation will be described.
The driver amplifier 14, the level limiting circuit, has the saturation characteristic that limits the amplitude of the RF signal level to a desired level.

More specifically, when the amplitude of the RF signal fed from the input side dividing circuit 2 is less than the specified level, the driver amplifier 14 supplies the RF signal to the carrier amplifier 3 without change. In contrast, when the amplitude of the RF signal is greater than the specified level, the driver amplifier 14 limits the amplitude of the RF signal to the specified level, and supplies it to the carrier amplifier 3.

Thus, it becomes possible to prevent the efficiency reduction in the area where the carrier amplifier 3 saturates completely by designing such that the upper limit of the amplitude of the RF signal limited by the driver amplifier 14 is placed near a region where the efficiency of the carrier amplifier 3 is maximum (themaximumefficiency is achieved near the saturation point of the carrier amplifier 3), which offers an advantage of being able to improve the efficiency and linearity of the entire amplifier.

### EMBODIMENT 5

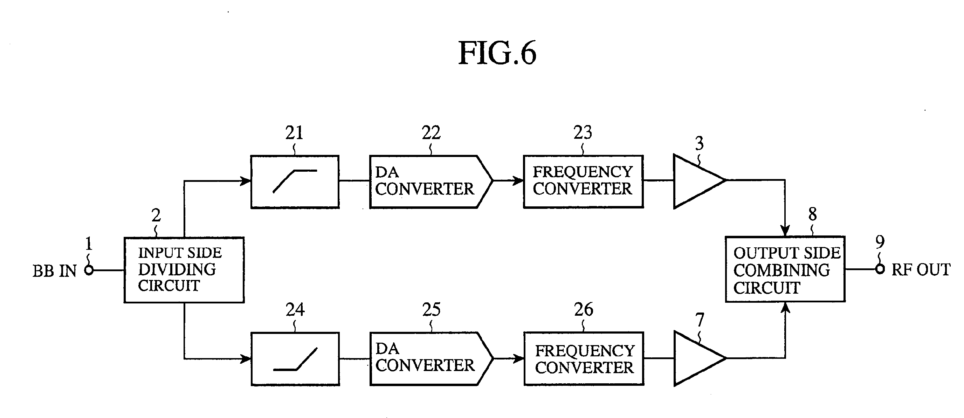

FIG. 6 is a block diagram showing a configuration of a high efficiency amplifier of an embodiment 5 in accordance with the present invention. In FIG. 6, since the same reference numerals designate the same or like portions to those of FIG. 1, their description is omitted here.
A waveform shaping circuit 21 or a level limiting circuit, which supplies a first BB (Base Band) signal fed from the input side dividing circuit 2 to a DA converter 22, limits, when the amplitude of the BB signal is greater than a threshold level A (specified level), the amplitude of the BB signal to below the threshold level A, and supplies it to the DA converter 22.
The DA converter 22 converts the digital BB signal, the output signal of the waveform shaping circuit 21, to an analog signal.
A frequency converter 23 up-converts the frequency of the analog signal, the output signal of the DA converter 22, to an RF frequency, and supplies it to the carrier amplifier 3.

A waveform shaping circuit 24, which supplies a second BB signal fed from the input side dividing circuit 2 to a DA converter 25, prevents the output of the BB signal to the DA converter 25 when the amplitude of the BB signal is less than a threshold level B (specified level).
The DA converter 25 converts the digital BB signal, the output signal of the waveform shaping circuit 24, to an analog signal.
A frequency converter 26 up-converts the frequency of the analog signal, the output signal of the DA converter 25, to an RF frequency, and supplies it to the peak amplifier 7.

Next, the operation will be described.
When the digital BB signal is input via the input terminal 1, the input side dividing circuit 2 divides the digital BB signal and supplies to the two paths.

In the first path, the waveform shaping circuit 21 supplies the first BB signal fed from the input side dividing circuit 2 to the DA converter 22. In this case, when the amplitude of the BB signal is greater than the threshold level A, the waveform shaping circuit 21 limits the amplitude of the BB signal to below the threshold level A, and supplies it to the DA converter 22. Thus, the waveform shaping circuit 21 carries out the waveform shaping for limiting the amplitude of the input signal to less than the threshold level A. Even if the amplitude of the input signal is less than the threshold level A, it is also possible to reduce the amplitude of the input signal when the amplitude of the input signal increases near the threshold level A (as the amplitude of the input signal is closer to the threshold level A, the magnitude of the reduction is increased).
Here, the threshold level A is set close to an area where the efficiency of the carrier amplifier 3 becomes maximum.

The DA converter 22 converts the digital BB signal, the output signal of the waveform shaping circuit 21, to the analog signal.
The frequency converter 23 up-converts the frequency of the analog signal, the output signal of the DA converter 22, to the RF frequency, and supplies it to the carrier amplifier 3.
The carrier amplifier 3 amplifies the analog signal, the output signal of the frequency converter 23.

In the second path, the waveform shaping circuit 24 supplies the second BB signal fed from the input side dividing circuit 2 to the DA converter 25. In this case, when the amplitude of the BB signal is less than the threshold level B, the waveform shaping circuit 24 does not output the BB signal to the DA converter 25.
Here, the threshold level B is set close to an area where the efficiency of the peak amplifier 7 becomes maximum.

The DA converter 25 converts the digital BB signal, the output signal of the waveform shaping circuit 24, to the analog signal.
The frequency converter 26 up-converts the frequency of the analog signal, the output signal of the DA converter 25, to the RF frequency, and supplies it to the peak amplifier 7.
The peak amplifier 7 amplifies the analog signal, the output signal of the frequency converter 26.

Incidentally, when the instantaneous signal level of the input signal is less than the specified level, the class B or class C biased peak amplifier 7 is placed in the off state (in which the input signal is not amplified) so that the output signal of the peak amplifier 7 is not supplied to the output side combining circuit 8.
Therefore the output side combining circuit 8 outputs the RF signal output from the carrier amplifier 3 to the output terminal 9.

In contrast, when the instantaneous signal level of the input signal is greater than the specified level, since the class B or class C biased peak amplifier 7 is placed in the on state (in which the signal is amplified), the output side combining circuit 8 combines the output signal of the carrier amplifier 3 with the output signal of the peak amplifier 7 and supplies to the output terminal 9.

As is clear from the above, the present embodiment 5 is configured such that when the amplitude of the first BB signal fed from the input side dividing circuit 2 is greater than the threshold level A, the waveform shaping circuit 21 limits the amplitude of the BB signal to less than the threshold level A, and supplies it to the DA converter 22. Accordingly, the present embodiment 5 can prevent the efficiency reduction in the area where the carrier amplifier 3 saturates completely, which offers an advantage of being able to improve the efficiency and linearity of the entire amplifier.

### EMBODIMENT 6

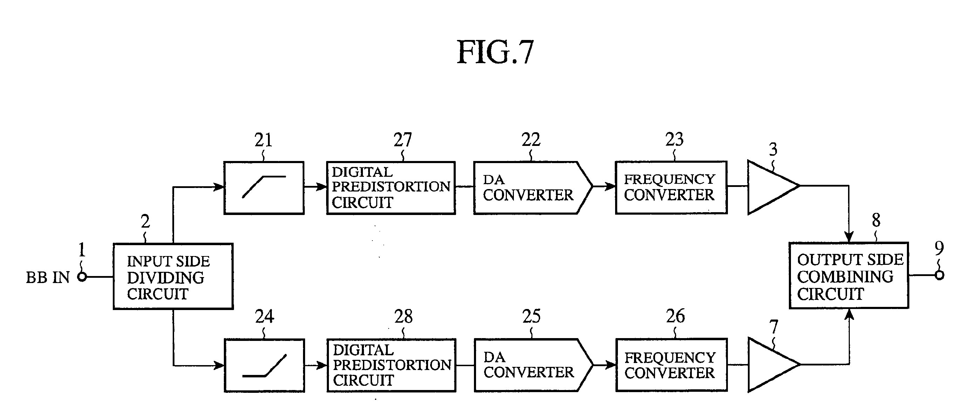

FIG. 7 is a block diagram showing a configuration of a high efficiency amplifier of an embodiment 6 in accordance with the present invention. In FIG. 7, since the same reference numerals designate the same or like portions to those of FIG. 6, their description is omitted here.
A digital predistortion circuit 27, which is connected between the waveform shaping circuit 21 and the DA converter 22, is a first distortion compensation circuit for compensating for the nonlinear distortion of the carrier amplifier 3.
A digital predistortion circuit 28, which is connected between the waveform shaping circuit 24 and the DA converter 25, is a second distortion compensation circuit for compensating for the nonlinear distortion of the peak amplifier 7.

Although the foregoing embodiment 5 does not include the digital predistortion circuit 27 or 28, the digital predistortion circuits 27 and 28 can be installed as shown in FIG. 7.
The digital predistortion circuit 27 compensates for the nonlinear distortion of the carrier amplifier 3, and the digital predistortion circuit 28 compensates for the nonlinear distortion of the peak amplifier 7. This makes it possible to further improve the linearity of the entire amplifier.

### EMBODIMENT 7

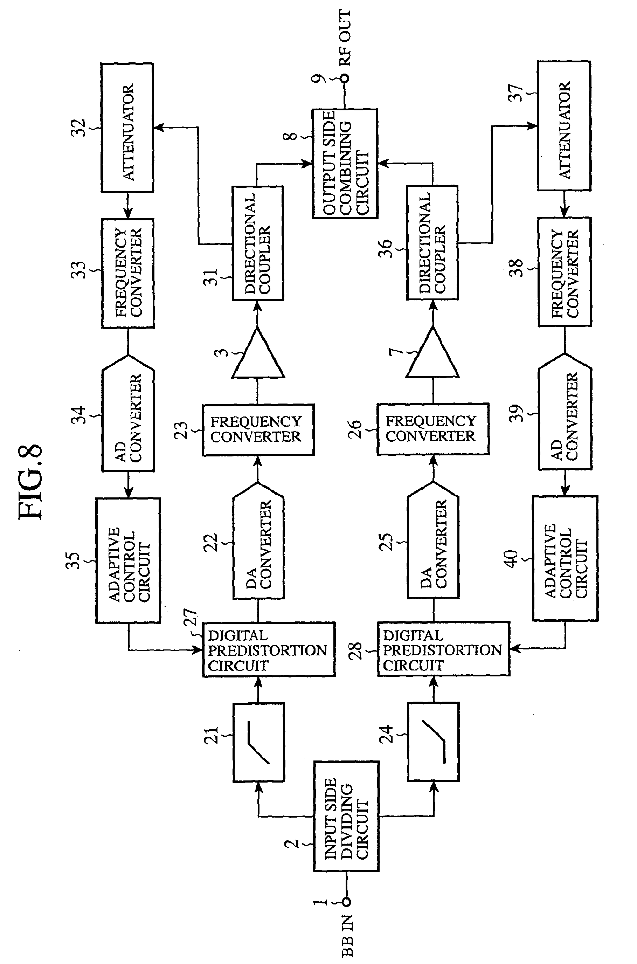

FIG. 8 is a block diagram showing a configuration of a high efficiency amplifier of an embodiment 7 in accordance with the present invention. In FIG. 8, since the same reference numerals designate the same or like portions to those of FIG. 7, their description is omitted here.
A directional coupler 31 extracts part of the RF signal, the output signal of the carrier amplifier 3, and supplies it to an attenuator 32. The attenuator 32 attenuates the RF signal fed from the directional coupler 31.

A frequency converter 33 down-converts the frequency of the RF signal attenuated by the attenuator 32, and supplies it to an AD converter 34. The AD converter 34 converts the analog signal, the output signal of the frequency converter 33, to a digital signal.
An adaptive control circuit 35 (first adaptive control circuit) adaptively varies the parameters (operation conditions) of the digital predistortion circuit 27 in response to the digital signal fed from the AD converter 34.

A directional coupler 36 extracts part of the RF signal, the output signal of the peak amplifier 7, and supplies it to an attenuator 37. The attenuator 37 attenuates the RF signal fed from the directional coupler 36.
A frequency converter 38 down-converts the frequency of the RF signal attenuated by the attenuator 37, and supplies it to an AD converter 39. The AD converter 39 converts the analog signal, the output signal of the frequency converter 38, to a digital signal.
An adaptive control circuit 40 (second adaptive control circuit) adaptively varies the parameters (operation conditions) of the digital predistortion circuit 28 in response to the digital signal fed from the AD converter 39.

Next, the operation will be described.
When the RF signal is output from the carrier amplifier 3 as in the foregoing embodiment 6, the directional coupler 31 extracts part of the RF signal and supplies it to the attenuator 32.
Receiving the RF signal from the directional coupler 31, the attenuator 32 attenuates the RF signal to a level suitable for the post-stage adaptive control circuit 35 to handle.

Receiving the RF signal attenuated by the attenuator 32, the frequency converter 33 down-converts the frequency of the RF signal and supplies to the AD converter 34.
The AD converter 34 converts the output signal of the frequency converter 33, which is the analog signal, to a digital signal.

Receiving the digital signal from the AD converter 34, the adaptive control circuit 35 adaptively varies the parameters of the digital predistortion circuit 27 in response to the digital signal.
More specifically, the RF signal output from the carrier amplifier 3 can vary because of temperature changes or device degradation. Thus, to prevent the variations of the RF signal because of these factors, the adaptive control circuit 35 adaptively varies the parameters of the digital predistortion circuit 27 to maintain the linearity of the RF signal output from the carrier amplifier 3.

When the RF signal is output from the peak amplifier 7 as in the foregoing embodiment 6, the directional coupler 36 extracts part of the RF signal and supplies it to the attenuator 37.
Receiving the RF signal from the directional coupler 36, the attenuator 37 attenuates the RF signal to a level suitable for the post-stage frequency converter 38 to handle.

Receiving the RF signal attenuated by the attenuator 37, the frequency converter 38 down-converts the frequency of the RF signal and supplies to the AD converter 39.
The AD converter 39 converts the output signal of the frequency converter 38, which is the analog signal, to a digital signal.

Receiving the digital signal from the AD converter 39, the adaptive control circuit 40 adaptively varies the parameters of the digital predistortion circuit 28 in response to the digital signal.
More specifically, the RF signal output from the peak amplifier 7 can vary because of temperature changes or device degradation. Thus, to prevent the variations of the RF signal because of these factors, the adaptive control circuit 40 adaptively varies the parameters of the digital predistortion circuit 28 to maintain the linearity of the RF signal output from the peak amplifier 7.

As is clear from the above, the present embodiment 7 is configured such that it adaptively varies the parameters of the digital predistortion circuits 27 and 28 in response to the RF signals output from the carrier amplifier 3 and peak amplifier 7. This offers an advantage of being able to implement stable, low distortion characteristics of the entire amplifier in spite of the variations in the characteristics of the carrier amplifier 3 and peak amplifier 7.

### EMBODIMENT 8

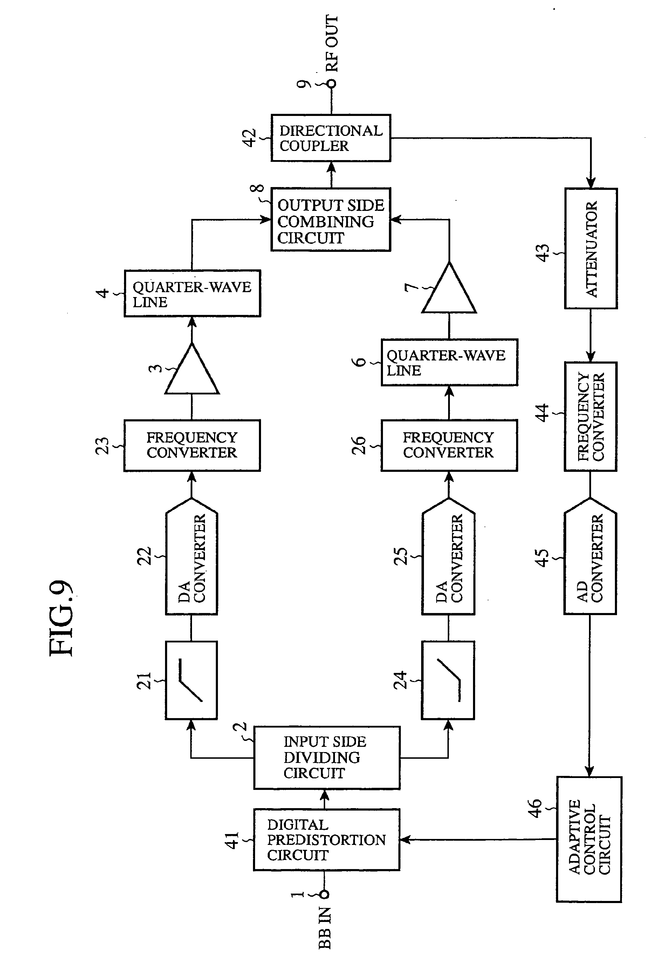

FIG. 9 is a block diagram showing a configuration of a high efficiency amplifier of an embodiment 8 in accordance with the present invention. In FIG. 9, since the same reference numerals designate the same or like portions to those of FIG. 6, their description is omitted here.
A digital predistortion circuit 41, which is connected between the input terminal 1 and the input side dividing circuit 2, is a distortion compensation circuit for compensating for the nonlinear distortion of the entire high efficiency amplifier.

A directional coupler 42 extracts part of the RF signal, the output signal of the output side combining circuit 8, and supplies it to an attenuator 43. The attenuator 43 attenuates the RF signal fed from the directional coupler 42.
A frequency converter 44 down-converts the frequency of the RF signal attenuated by the attenuator 43, and supplies it to an AD converter 45. The AD converter 45 converts the analog signal, the output signal of the frequency converter 44, to a digital signal.
An adaptive control circuit 46 adaptively varies the parameters (operation conditions) of the digital predistortion circuit 41 in response to the digital signal output from the AD converter 45.

Next, the operation will be described.
Although the foregoing embodiment 7 is described by way of example where the digital predistortion circuits 27 and 28 are connected after the waveform shaping circuits 21 and 24, this is not essential. For example, a configuration is also possible in which the digital predistortion circuit 41 is connected between the input terminal 1 and the input side dividing circuit 2.
In this case, the digital predistortion circuit 41 compensates for the nonlinear distortion of the entire high efficiency amplifier.

As in the foregoing embodiment 1, when the instantaneous signal level of the input signal is less than the specified level in the present embodiment 8, the class B or class C biased peak amplifier 7 is placed in the off state (in which the input signal is not amplified) so that the output signal of the peak amplifier 7 is not supplied to the output side combining circuit 8.
Accordingly, the output side combining circuit 8 supplies the RF signal output from the carrier amplifier 3 to the output terminal 9.
In contrast, when the instantaneous signal level of the input signal is greater than the specified level, the class B or class C biased peak amplifier 7 is placed in the on state (in which the signal is amplified) so that the output side combining circuit 8 combines the output signal of the carrier amplifier 3 with the output signal of the peak amplifier 7 and supplies to the output terminal 9.

When the RF signal is output from the output side combining circuit 8, the directional coupler 42 extracts part of the RF signal and supplies it to the attenuator 43.
Receiving the RF signal from the directional coupler 42, the attenuator 43 attenuates the RF signal to a level suitable for the post-stage frequency converter 44 to handle.

Receiving the RF signal attenuated by the attenuator 43, the frequency converter 44 down-converts the frequency of the RF signal and supplies to the AD converter 45.
The AD converter 45 converts the output signal of the frequency converter 44, which is the analog signal, to a digital signal.

Receiving the digital signal from the AD converter 45, the adaptive control circuit 46 adaptively varies the parameters of the digital predistortion circuit 41 in response to the digital signal.
More specifically, the RF signal output from the output side combining circuit 8 can vary because of temperature changes or device degradation. Thus, to prevent the variations of the RF signal because of these factors, the adaptive control circuit 46 adaptively varies the parameters of the digital predistortion circuit 41 to maintain the linearity of the RF signal output from the output side combining circuit 8.

As is clear from the above, the present embodiment 8 is configured such that it adaptively varies the parameters of the digital predistortion circuit 41 in response to the RF signal output from the AD converter 45. This offers an advantage of being able to implement stable, low distortion characteristics of the entire amplifier in spite of the variations in the characteristics of the high efficiency amplifier.

### INDUSTRIAL APPLICABILITY

As described above, the high efficiency amplifier in accordance with the present invention is suitable for the broadcasting or communication RF amplifiers that must amplify the RF signal at high efficiency with high linearity.

## Claims

1. A high efficiency amplifier including input signal dividing means for splitting an input signal; a first amplifier for amplifying a first input signal fed from said input signal dividing means; a second amplifier for amplifying, when power of a second input signal fed from said input signal dividing means is greater than specified power, the second input signal; and a combining circuit for combining an output signal of said first amplifier and an output signal of said second amplifier, said high efficiency amplifier comprising before said second amplifier: a distortion compensation circuit for compensating for nonlinear distortion of said second amplifier.

2. The high efficiency amplifier according to claim 1, further comprising a distortion compensation circuit for compensating for nonlinear distortion of said first amplifier before said first amplifier.

3. A high efficiency amplifier including input signal dividing means for splitting an input signal; a first amplifier for amplifying a first input signal fed from said input signal dividing means; a second amplifier for amplifying, when power of a second input signal fed from said input signal dividing means is greater than specified power, the second input signal; and a combining circuit for combining an output signal of said first amplifier and an output signal of said second amplifier, said high efficiency amplifier comprising before said first amplifier: a level limiting circuit for limiting, when amplitude of the first input signal fed from said input signal dividing means is greater than a specified level, the amplitude of the first input signal to less than the specified level, and for supplying to said first amplifier.

4. The high efficiency amplifier according to claim 3, wherein said level limiting circuit is a limiter circuit.

5. The high efficiency amplifier according to claim 3, wherein said level limiting circuit is a driver amplifier having a saturation characteristic.

6. The high efficiency amplifier according to claim 3, wherein said level limiting circuit is a waveform shaping circuit.

7. The high efficiency amplifier according to claim 6, further comprising before said second amplifier a waveform shaping circuit that suppresses output of a signal when amplitude of the second input signal fed from said input signal dividing means is less than a specified level.

8. The high efficiency amplifier according to claim 7, further comprising a first distortion compensation circuit for compensating for nonlinear distortion of said first amplifier before said first amplifier; and a second distortion compensation circuit for compensating for nonlinear distortion of said second amplifier before said second amplifier.

9. The high efficiency amplifier according to claim 8, further comprising a first adaptive control circuit for varying parameters of said first distortion compensation circuit in response to the output signal of said first amplifier; and a second adaptive control circuit for varying parameters of said second distortion compensation circuit in response to the output signal of said second amplifier.

10. A high efficiency amplifier including input signal dividing means for splitting an input signal; a first amplifier for amplifying a first input signal fed from said input signal dividing means; a second amplifier for amplifying a second input signal fed from said input signal dividing means; and a combining circuit for combining an output signal of said first amplifier and an output signal of said second amplifier, said high efficiency amplifier comprising: a first waveform shaping circuit before said first amplifier, said first waveform shaping circuit limiting, when amplitude of the first input signal fed from said input signal dividing means is greater than a specified level, the amplitude of the first input signal to less than a specified level, and supplying to said first amplifier; and a second waveform shaping circuit before said second amplifier, said second waveform shaping circuit suppressing output of a signal when amplitude of the second input signal fed from said input signal dividing means is less than a specified level.

11. The high efficiency amplifier according to claim 10, wherein said first waveform shaping circuit has a characteristic of gradually limiting the amplitude of the input signal as the amplitude of the input signal approaches the specified level.

12. The high efficiency amplifier according to claim 1, wherein said distortion compensation circuit is placed before said input signal dividing means rather than before said second amplifier.

13. The high efficiency amplifier according to claim 12, further comprising an adaptive control circuit for varying parameters of said distortion compensation circuit in response to the combined signal output from said combining circuit.
